# EUROPÄISCHE PATENTSCHRIFT

(11) **EP 0 429 955 B1**
(45) Veröffentlichungstag und Bekanntmachung des Hinweises auf die Patenterteilung: **23.10.1996**
(21) Anmeldenummer: 90121785.1
(22) Anmeldetag: 14.11.1990
(51) Int. Cl.: G03F 7/004

(54) **Verfahren zur Herstellung einer negativ arbeitenden lichtempfindlichen Druckform**
Process for preparing a negative-working printing plate
Méthode de préparation d'une plaque d'impression photosensible négative

(30) Priorität: 23.11.1989 DE 3938788
(43) Veröffentlichungstag der Anmeldung: 05.06.1991
(73) Patentinhaber: Agfa-Gevaert AG, D-51373 Leverkusen (DE)
(72) Erfinder: Neubauer, Rudolf, Dr. Dipl.-Chem., W-6227 Oestrich-Winkel (DE); Keiper, Roman, W-6209 Heidenrod (DE); Nürnberger, Siegfried, W-6228 Eltville-Martinsthal (DE); Maus, Sabine, W-6533 Bacharach-Steeg (DE)

(56) Entgegenhaltungen:
- EP-A- 0 410 277
- EP-A- 0 412 765
- DE-A- 3 807 406
- PATENT ABSTRACTS OF JAPAN, vol. 12, no. 463 (P-796)(3310) 6. Dezember 1988 & JP-A-63 186 248

## Beschreibung

Die vorliegende Erfindung betrifft ein Verfahren zur Herstellung einer negativ arbeitenden lichtempfindlichen, lithographischen Druckform, bei dem auf einem Träger ein in einer Lösemittelmischung gelöstes, negativ arbeitendes, lichtempfindliches Gemisch, das eine negativ arbeitende lichtempfindliche Verbindung, ein in Wasser unlösliches, in wäßrig-alkalischer Lösung aber lösliches polymeres Bindemittel enthält, aufgetragen und die erhaltene Schicht anschließend getrocknet wird.

Bei der Herstellung von lithographischen Druckformen werden die lichtempfindlichen Gemische kontinuierlich auf einen Träger aufgebracht. Der beschichtete Träger wird dann getrocknet, damit ein dünner Film mit gleichmäßiger Dicke entsteht. Das Lösemittel bzw. Lösemittelgemisch sollte daher nach der Beschichtung gleichmäßig antrocknen und eine gute Oberflächenbeschaffenheit (Oberflächenkosmetik) zeigen, d.h. das Auftreten von "fisheyes", Ausfällungen und "Wolken" unterbinden. Darüber hinaus muß sich das Lösemittel bzw. Lösemittelgemisch verdampfen lassen, ohne einen großen Rückstand zu bilden.

Die Anforderungen an ein geeignetes Lösemittel bzw. Lösemittelgemisch beschränken sich nicht nur auf den unmittelbaren Zeitraum, der das Trocknen des Gemisches betrifft, sondern auch auf die Eigenschaften der Lösung vor dem Aufbringen auf den Träger. Hierbei ist in erster Linie zu nennen, daß sämtliche Schichtbestandteile in optimaler Weise in der notwendigen Konzentration lösbar sind. Darüber hinaus muß das Lösemittel bzw. Lösemittelgemisch eine Lösungsstabilität über einen gewissen Zeitraum - bevorzugt über einige Tage - garantieren, ohne daß es zu Zersetzungen, Ausfällungen und Kondensationsreaktionen kommt. Außerdem werden eine preiswerte Verfügbarkeit und eine möglichst geringe Toxizität verlangt.

In der DE-A 20 34 655 (= US-A 3 790 385) wird ein Lösemittelgemisch für ein negativ arbeitendes lichtempfindliches Kopiermaterial vorgeschlagen, das entsprechend der dort beschriebenen Beispiele aus Ethylenglykolmonomethylether, Tetrahydrofuran und Butylacetat besteht, mithin alles Lösemittel mit Siedepunkten unter 140 °C. Es zeigte sich jedoch, daß negativ arbeitende lichtempfindliche Gemische, die solche Lösemittelgemische enthalten, weniger haltbar sind, d.h., daß sich schon nach Stunden Ausfällungen und Zersetzungen zeigen. Zudem kann man feststellen, daß die Beschichtungs- und Trocknungseigenschaften nur bedingt vorteilhaft sind.

In der DE-A 36 27 585 wird ein Verfahren zur Herstellung vorsensibilisierter Flachdruckformen auf der Basis von negativ arbeitenden lichtempfindlichen Gemischen vorgestellt, bei dem das lichtempfindliche Diazoniumharz und das hochmolekulare, in wäßrigem Alkali lösliche Bindemittel in einer Vielzahl verschiedener Lösemittel mit unterschiedlichen Siedepunkten gelöst werden können. Mischungen dieser Lösemittel werden auch beschrieben.

Insbesondere werden Mischungen von Lösemitteln in den EP-A 0 184 804 und 0 152 819 (= US-A 4 631 245) (2-Methoxyethanol mit Tetrahydrofuran) und EP-A 0 031 481 (Butylacetat, 2-Methoxyethanol und Tetrahydrofuran) beschrieben.

Die DE-A 38 07 406 (= GB-A 2 204 707) offenbart ein Lösemittelgemisch für negativ arbeitende lichtempfindliche lithographische Platten, das 1-Methoxy-2-propanol, Methyllactat und Methylethylketon umfaßt. Zu diesen niedrigsiedenden Lösemitteln können bis zu 2 % eines höhersiedenden Lösemittels zugesetzt werden. Mit den beschriebenen Lösemittelgemischen konnten allerdings keine homogenen Lösungen erhalten werden. Ein Teil der Feststoffe bleibt ungelöst zurück.

Insgesamt gesehen kann man nach dem Stand der Technik nur sehr verdünnte Lösungen der Schichtbestandteile herstellen, so daß sehr viel Lösemittel zur Auflösung sämtlicher Schichtbestandteile benötigt werden. Ebenso zeigen einmal mit einem Lösemittelgemisch hergestellt Schichten während des Trocknungsprozesses Schichtausfällungen, Schichtstörungen und wolkiges Aussehen. Damit verbunden ist eine geringe Haltbarkeit der lichtempfindlichen Lösungen. Häufig kommt es auch zum Auskristallisieren von Schichtbestandteilen schon bei geringfügiger Temperaturabsenkung.

Aufgabe der vorliegenden Erfindung ist es daher, ein Verfahren zur Herstellung einer negativ arbeitenden, lichtempfindlichen, lithographischen Druckform bereitzustellen, die die genannten Nachteile nicht aufweist.

Gelöst wird die Aufgabe durch ein Verfahren zur Herstellung einer negativ arbeitenden lichtempfindlichen, thographischen Druckform, bei dem auf einen Träger ein in einer Lösemittelmischung gelöstes, negativ arbeitendes, lichtempfindliches Gemisch, das
a) ein negativ arbeitendes lichtempfindliches Diazoniumsalz-Polykondensationsprodukt enthält, das Diazoniumsalzeinheiten A-N₂X und andere, nicht lichtempfindliche Einheiten enthält, die von kondensationsfähigen Verbindungen, insbesondere aromatischen Aminen, Phenolen, Phenolethern, aromatischen Thioethern, aromatischen Kohlenwasserstoffen, aromatischen Heterocyclen und Carbonsäureamiden, abgeleitet sind, wobei sich die Einheiten A-N₂X von Verbindungen der Formel (R⁸-R⁹-)ₚR¹⁰-N₂X ableiten, worin
   - X: das Anion der Diazoniumverbindung,
   - p: eine ganze Zahl von 1 bis 3,
   - R⁸: einen aromatischen Rest mit mindestens einer zur Kondensation mit aktiver Carbonylverbundung befähigten Position,
   - R¹⁰: eine Phenylengruppe,
   - R⁹: eine Einfachbindung oder eine der Gruppen:

   -(CH₂)_{q}-NR¹¹-,

   -O-(CH₂)ᵣ-NR¹¹-,

   -S-(CH₂)ᵣ-NR¹¹-,

   -S-CH₂CO-NR¹¹-,

   -O-R¹²-O-,

   - O -,

   - S -

   oder

   -CO-NR¹¹-

   bedeuten, worin
   - q: eine Zahl von 0 bis 5,
   - r: eine Zahl von 2 bis 5,
   - R¹¹: Wasserstoff; eine Alkylgruppe mit 1 bis 5 C-Atomen, eine Aralkylgruppe mit 7 bis 12 C-Atomen oder eine Arylgruppe mit 6 bis 12 C-Atomen, und
   - R¹²: eine Arylengruppe mit 6 bis 12 C-Atomen ist, und
b) ein in Wasser unlösliches, in wäßrig-alkalischer Lösung lösliches polymeres Bindemittel enthält,
   aufgetragen und die erhaltene Schicht anschließend getrocknet wird, dadurch gekennzeichnet, daß als Lösemittelmischung ein Gemisch aus mehr als 10 und weniger als 50 Gew.-% mindestens eines Monoethers des Diethylenglykols und einem oder mehreren organischen Lösemittel(n) mit einem Siedepunkt unterhalb 200 °C verwendet wird.

Die Lösemittelgemische der vorliegenden Erfindung besitzen nicht die Nachteile der Gemische des Standes der Technik. Sie führen im Gegenteil zu stabilen lichtempfindlichen Lösungen in den erwünschten höheren Konzentrationen, ermöglichen einen gleichmäßigen Antrocknungsprozeß ohne vorzeitige Ausfällung von Schichtbestandteilen mit einer bisher unerreicht gleichmäßigen Oberfläche und ermöglichen die Herstellung von Flachdruckformen mit gleichmäßigem Eigenschaftsbild bezüglich der Lichtempfindlichkeit, Entwickelbarkeit und Tonfreiheit im Druckprozeß.

Insbesondere bevorzugt sind Monoalkylether des Diethylenglykols, vorzugsweise die Mono(C₁-C₄)alkylether. Hierunter sind zu nennen: Diechylenglykolmonomethylether, Diethylenglykolmonoethylether, Diethylenglykolmonopropylether sowie entsprechende Monobutylether.

Als weitere Lösemittelbestandteile des erfindungsgemäß verwendeten Gemisches werden niedrigsiedende organische Lösemittel mit einem Siedepunkt unterhalb 200 °C verwendet. Insbesondere haben die niedrigsiedenden Lösemittel einen Siedepunkt von 50 bis 150 °C, vorzugsweise von 50 bis 100 °C. Diese können ein oder mehrere Lösemittel sein aus der Gruppe der Lösemittel Aceton, Butanon-2, Methanol, Ethanol, n-Propanol, Isopropanol, n-Butanol, 2-Methoxyethanol, 1-Methoxyisopropanol, 2-Methoxy-1-propanol, Amylalkohol, Tetrahydrofuran, 1,4-Dioxan, Wasser, Toluol, Diethylether, Diisopropylether, Dibutylether, 2-Methylfuran, Cyclohexanon, Methylisobutylketon, Methylpropylketon, Methylisopropylketon, Methylbutylketon, Ethylformiat, Propylformiat, Butylformiat, Methylacetat, Ethylacetat, Propylacetat, Butylacetat, Methylpropionat, Ethylenglykoldimethylether, Ethylenglykoldiethylether, Dimethylsulfoxid, Dimethylformamid, q-Butyrolacton, Diacetonalkohol.

Von den hochsiedenden Monoalkylethern sind besonders bevorzugt die Mono(C₁-C₄)alkylether des Diethylenglykols.

Von den niedrigsiedenden Lösemitteln, insbesondere solchen mit einem Siedepunkt unterhalb 200 °C, sollen Tetrahydrofuran, Butanon-2 und Ethanol erwähnt werden.

Insbesondere bevorzugt sind Mischungen eines Lösemittels vom Typ eines Monoethers des Diethylenglykols mit einem oder zwei Lösemittel(n) eines niedrigen Siedepunkts unterhalb von 200 °C. Insbesondere liegt das Mischungsverhältnis vom hochsiedenden Monoether des Diethylenglokols zum niedrigsiedenden Lösemittel bei 1:1 bis 0,2:1, vorzugsweise bei 1:1 bis 0,4:1 (Gewichtsverhältnisse).

Die Schichtzusammensetzung geeigneter lichtempfindlicher Gemische ist seit langem bekannt. Stellvertretend sollen hier nur die DE-A 20 34 654 (= GB-A 1 358 923) und EP-A 0 152 819 genannt werden.

Im erfindungsgemäßen Verfahren werden als lichtempfindliche Verbindungen Mischkondensationsprodukte verwendet, die außer den Diazoniumsalzeinheiten noch andere, nicht lichtempfindliche Einheiten enthalten, die von kondensationsfähigen Verbindungen, insbesondere aromatischen Aminen, Phenolen, Phenolethern, aromatischen Thioethern, aromatischen Kohlenwasserstoffen, aromatischen Heterocyclen und Carbonsäureamiden, abgeleitet sind. Diese Kondensationsprodukte sind in der DE-A 20 24 244 beschrieben. Allgemein sind alle Diazoniumsalz-Polykondensationsprodukte geeignet, die in der DE-A 27 39 774 beschrieben sind.

Die lichtempfindliche Schicht enthält im allgemeinen 5 bis 90 Gew.-%, bevorzugt 10 bis 70 Gew.-%, Diazoniumverbindung.

Zur Stabilisierung des erfindungsgemäßen lichtempfindlichen Gemisches ist es vorteilhaft, diesem eine Verbindung mit Säurecharakter zuzusetzen. In Betracht kommen Mineralsäuren und starke organische Säuren, von denen Phosphorsäure, Schwefelsäure, Perchlorsäure, Borsäure oder p-Toluolsulfonsäure bevorzugt werden. Eine besonders gut geeignete Säure ist die Phosphorsäure.

Den Gemischen können ferner Weichmacher, Haftvermittler, Farbstoffe, Pigmente und Farbbildner zugesetzt werden.

Art und Menge dieser Zusätze richten sich nach dem für das lichtempfindliche Gemisch vorgesehenen Anwendungsgebiet. Dabei ist grundsätzlich zu beachten, daß die beigefügten Stoffe keinen übergroßen Anteil des für die Vernetzung notwendigen aktinischen Lichts absorbieren und dadurch die praktische Lichtempfindlichkeit herabsetzen.

Die erfindungsgemäß verwendeten, lichtempfindlichen Gemische können ferner Farbstoffe und/oder Pigmente enthalten, die sowohl als Kontrastmittel als auch schichtverfestigend wirken können. In Frage kommende Farbstoffe sind beispielsweise in den US-A 3 218 167 und 3 884 693 angegeben. Besonders geeignet sind z. B. Viktoriareinblau FGA, Renolblau B2G-H (C.I. 74160), Kristallviolett oder Rhodamin 6 GDN (C.I. 45160). Zur Erhöhung des Bildkontrastes nach dem Belichten können Metanilgelb (C.I. 13065), Methylorange (C.I. 13025) oder Phenylazodiphenylamin verwendet werden.

Ebenso geeignet sind negativ arbeitende, lichtempfindliche Schichten, die sowohl eine lichtempfindliche Verbindung gemäß Anspruch 1 als auch eine photopolymerisierbare Verbindung enthalten.

Beispiele für verwendbare Bindemittel sind chloriertes Polyethylen, chloriertes Polypropylen, Poly(meth)acrylsäurealkylester, bei denen die Alkylgruppe z. B. Methyl, Ethyl, n-Butyl, i-Butyl, n-Hexyl oder 2-Ethylhexyl ist, Copolymere der genannten (Meth)acrylsäurealkylester mit mindestens einem Monomeren, wie Acrylnitril, Vinylchlorid, Vinylidenchlorid, Styrol oder Butadien; Polyvinylchlorid, Vinylchlorid/ Acrylnitril-Copolymere, Polyvinylidenchlorid, Vinylidenchlorid/Acrylnitril-Copolymere, Polyvinylacetat, Polyvinylalkohol, Polyacrylnitril, Acrylnitril/Styrol-Copolymere, Acrylnitril/Butadien/Styrol-Copolymere, Polystyrol, Polymethylstyrol, Polyamide (z. B. Nylon-6), Polyurethane, Methylcellulose, Ethylcellulose, Acetylcellulose, Polyvinylformal und Polyvinylbutyral.

Besonders geeignet sind Bindemittel, die in Wasser unlöslich, in organischen Lösemitteln löslich und in wäßrig-alkalischen Lösungen löslich oder zumindest quellbar sind.

Besonders erwähnt werden sollen Carboxylgruppen enthaltende Bindemittel, z. B. Copolymerisate aus (Meth)acrylsäure und/oder deren ungesättigten Homologen, wie Crotonsäure, Copolymerisate des Maleinsäureanhydrids oder seiner Halbester, Umsetzungsprodukte hydroxylgruppenhaltiger Polymerer mit Dicarbonsäureanhydriden sowie deren Mischungen.

Weiterhin sind geeignet umsetzungsprodukte aus Polymeren, die H-acide Gruppen tragen, welche ganz oder teilweise mit aktivierten Isocyanaten umgesetzt wurden, wie beispielsweise Umsetzungsprodukte aus hydroxylgruppenhaltigen Polymeren mit aliphatischen oder aromatischen Sulfonylisocyanaten oder Phosphinsäureisocyanaten.

Darüber hinaus sind geeignet: Hydroxylgruppen enthaltende Polymere, wie beispielsweise Copolymere von Hydroxyalkyl(meth)acrylaten, Copolymere des Allylalkohols, Copolymere des Vinylalkohols, Polyurethane oder Polyester, sowie Epoxyharze, sofern sie eine ausreichende Anzahl von freien OH-Gruppen tragen, oder derart modifiziert sind, daß sie in wäßrig-alkalischen Lösungen löslich sind, oder solche Polymere, die aromatisch gebundene Hydroxylgruppen tragen, wie beispielsweise Kondensationsprodukte von kondensationsfähigen Carbonylverbindungen, insbesondere Formaldehyd, Acetaldehyd oder Aceton, mit Phenolen oder Copolymerisate der Hydroxystyrole. Schließlich lassen sich auch Copolymerisate des (Meth)acrylsäureamids mit Alkyl(meth)acrylaten verwenden.

Die vorstehend beschriebenen Polymeren sind insbesondere dann geeignet, wenn sie ein Molekulargewicht zwischen 500 und 200 000 oder darüber, bevorzugt 1 000 bis 100 000 aufweisen und entweder Säurezahlen zwischen 10 und 250, bevorzugt von 20 bis 200, oder Hydroxylzahlen zwischen 50 und 750, bevorzugt von 100 bis 500, aufweisen.

Als bevorzugte alkalilösliche Bindemittel seien nachstehend erwähnt:

Copolymerisate der (Meth)acrylsäure mit Alkyl(meth)acrylaten, (Meth)acrylsäurenitril oder dergleichen, Copolymerisate der Crotonsäure mit Alkyl(meth)acrylaten, (Meth)acrylsäurenitril oder dergleichen, Copolymerisate der Vinylessigsäure mit Alkyl(meth)acrylaten, Copolymerisate des Maleinsäureanhydrids mit ggf. substituierten Styrolen, ungesättigten Kohlenwasserstoffen, ungesättigten Ethern oder Estern, Veresterungsprodukte der Copolymerisate des Maleinsäureanhydrids, Veresterungsprodukte von Hydroxylgruppen enthaltenden Polymeren mit Anhydriden von Di- oder Polycarbonsäuren, Copolymerisate der Hydroxyalkyl(meth)acrylate mit Alkyl(meth)acrylaten, (Meth)acrylsäurenitril oder dergleichen, Copolymerisate des Allylalkohols mit ggf. substituierten Styrolen, Copolymerisate des Vinylalkohols mit Alkyl(meth)acrylaten oder anderen polymerisationsfähigen ungesättigten Verbindungen, Polyurethane, sofern sie eine ausreichende Anzahl freier OH-Gruppen aufweisen, Epoxyharze, Polyester, teilverseifte Vinylacetat-Copolymere, Polyvinylacetale mit freien OH-Gruppen, Copolymerisate der Hydroxystyrole mit Alkyl(meth)acrylaten oder dergleichen, Phenol-Formaldehyd-Harze, z. B. Novolake.

Die Menge des Bindemittels in der lichtempfindlichen Schicht beträgt im allgemeinen 20 bis 90, vorzugsweise bis 80 Gew.-%.

Als Träger, auf denen das erfindungsgemäß verwendete, lichtempfindliche Gemisch aufgebracht wird, kommen solche in Frage, die eine hohe Formbeständigkeit aufweisen. üblicherweise zählen hierunter Träger für Druckplatten. Geeignet sind Papier, Aluminium oder seine Legierungen, einschließlich derjenigen, die mit einem Kunststoffilm, z. B. auf Polyethylenterephthalat oder Celluloseacetat laminiert sind, Metallplatten wie Stahl-, Zink- und Kupferplatten sowie Kunststoffilme. Besonders bevorzugt sind Aluminiumträger.

Von den Aluminiumträgern sind solche bevorzugt, deren Oberflächen aufgerauht wurden. Verschiedene, dem Fachmann bekannte Körnungsverfahren stehen zur Verfügung, insbesondere mechanische, chemische und elektrolytische sowie kombinierte Verfahren. Anschließend kann eine anodische Oxidation der Oberfläche unter Verwendung von Säuren wie Schwefel-, Phosphor- oder Salpetersäure etc. unter Gleichstrom oder Wechselstrom durchgeführt werden. Insbesondere werden die in dieser Weise vorbehandelten Aluminiumoberflächen mit Polyvinylphosphonsäure nachbehandelt (DE-C 11 34 093, GB-A 1 230 447). Aber auch andere Nachbehandlungsmethoden sind möglich wie z. B. mit einem Silikat, Kaliumfluorzirkonat, Phosphormolybdat, einer Polyacrylsäure, Phosphonsäure oder Phytinsäure. Besonders bevorzugt ist die Nachbehandlung mit einer 0,1%igen wäßrigen Lösung von Polyvinylphosphonsäure.

Das erfindungsgemäß verwendete negativ arbeitende, lichtempfindliche Gemisch wird in einer Menge von 0,3 bis 5,0 g/m², insbesondere 0,5 bis 3,5 g/m², bezogen auf die gesamten Bestandteile des lichtempfindlichen Gemisches, auf den Träger aufgetragen. Das lichtempfindliche Gemisch wird durch bekannte Verfahren - wie Sprüh-, Streich-, Rakel- oder Schleuderbeschichtung - aufgebracht. Eine Vortrocknung bei einer niedrigen Temperatur ist möglich.

Nach dem Trocknen wird das erf indungsgemäß verwendete lichtempfindliche Aufzeichnungsmaterial mit aktinischem Licht belichtet. Als aktinische Strahlung soll im Rahmen dieser Beschreibung jede Strahlung verstanden werden, deren Energie wenigstens der des sichtbaren Lichts entspricht. Geeignet sind vor allem sichtbares Licht und langwellige UV-Strahlung, aber auch kurzwellige UV-Strahlung sowie Laser-, Elektronen- und Röntgenstrahlung. Die Lichtempfindlichkeit reicht von etwa 200 nm bis 800 nm und umspannt damit einen sehr breiten Bereich.

Durch die breite spektrale Empfindlichkeit des erfindungsgemäß verwendeten Auf zeichnungsmaterials können alle dem Fachmann geläufigen Lichtquellen verwendet werden, z. B. Röhren-, Xenonimpuls-, metallhalogeniddotierte Quecksilberdampf-Hochdruck- und Kohlenbogenlampen. Darüber hinaus ist bei den erfindungsgemäßen lichtempfindlichen Gemischen das Belichten in üblichen Projektions- und Vergrößerungsgeräten unter dem Licht der Metallfadenlampen und Kontaktbelichtung mit gewöhnlichen Glühbirnen möglich. Die Belichtung kann auch mit kohärentem Licht eines Lasers erfolgen. Geeignet für die Zwecke vorliegender Erfindung sind leistungsgerechte Laser, beispielsweise Argon-Ionen-, Krypton-Ionen-, Farbstoff-, Helium-Cadmium- und Helium-Neon-Laser, die insbesondere zwischen 150 und 650 nm emittieren. Der Laserstrahl kann mittels einer vorgegebenen programmierten Strich- und/oder Raster-Bewegung gesteuert werden.

Als Anwendungsmöglichkeiten für das erfindungsgemäße Material seien genannt: Aufzeichnungsschichten für die photomechanische Herstellung von Druckformen für den Hochdruck, Flachdruck, Tiefdruck und den Siebdruck sowie von Reliefkopien, z. B. zur Herstellung von Texten in Blindenschrift, von Einzelkopien, Gerbbildern, Pigmentbildern usw.. Weiter sind die Gemische zur photomechanischen Herstellung von Ätzreservagen, z. B. für die Herstellung von Namensschildern, von kopierten Schaltungen und für das Formteilätzen anwendbar. Besondere Bedeutung haben die erfindungsgemäßen Gemische als Aufzeichnungsschichten für die Herstellung von Flachdruckplatten und für die Photoresisttechnik.

Zur besseren Verwendung der Schicht kann eine Nacherwärmung nach dem Belichten erfolgen. Zur Entwicklung wird mit einer geeigneten Entwicklerlösungl z. B. mit organischen Lösemitteln, bevorzugt aber mit einer schwach alkalischen, wäßrigen Lösung, behandelt. Der pH-Wert des Entwicklers liegt bei 8 bis 12. Die Entwicklerlösung kann einen kleinen Anteil, vorzugsweise weniger als 2 Gew.-%, an mit Wasser mischbaren organischen Lösemitteln enthalten.

Im Folgenden werden Ausführungsbeispiele für die Entwicklung angegeben. Darin stehen Gewichtsteile (Gt) und Volumenteile (Vt) im Verhältnis von g zu cm³. Prozentund Mengenverhältnisse sind, wenn nichts anderes angegeben ist, in Gewichtseinheiten zu verstehen.

Die folgenden Beispiele erläutern die Erfindung:

### Beispiel 1

50 Gt eines Polyvinylbutyrals mit einem Molekulargewicht von etwa 70.000 bis 80.000, das 71 % Vinylbutyral-, 2 % Vinylacetat- und 27 % Vinylalkoholeinheiten enthält, und 4 Gt Maleinsäureanhydrid werden unter Erwärmen in 725 Gt Methylethylketon gelöst. Zur klaren Lösung wird 1 Gt Triethylamin hinzugefügt und die Lösung fünf Stunden zum Rückfluß erhitzt. Nach dem Abkühlen wird die Lösung filtriert und in 10.000 Gt destilliertes Wasser eingetropft, wobei man ein weißes, faseriges Produkt erhält, welches abgesaugt und bis zur Gewichtskonstanz im Vakuum bei 40 °C getrocknet wird.

Die Ausbeute beträgt 52 Gt des Polymeren (Analyse: C 61,9 %; H 9,3 %) mit der Säurezahl 30.

Eine Beschichtungslösung aus
- 62 Gt: des oben beschriebenen Polymeren,
- 21 Gt: eines Diazoniumsalz-Polykondensationsprodukts, hergestellt aus 1 mol 3-Methoxy-diphenylamin-4-diazoniumsulfat und 1 mol 4,4'-Bis-methoxydiphenylether in 85%iger Phosphorsäure und isoliert als Mesitylensufonat,
- 2,5 Gt: Phosphorsäure (85 %),
- 3 Gt: Viktoriareinblau FGA (C.I. Basic Blue 81) und
- 0,7 Gt: Phenylazodiphenylamin in
- 1.600 Gt: Diethylenglykolmonomethylether und
- 1.750 Gt: Tetrahydrofuran
wird auf eine Aluminiumfolie, die durch Bürsten mit einer wäßrigen Schleifmittelsuspension aufgerauht und danach mit einer 0,1%igen wäßrigen Lösung von Polyvinylphosphonsäure vorbehandelt worden ist, aufgebracht und anschließend getrocknet.

Die so erhaltene Kopierschicht, die ein Schichtgewicht von 0,95 g/m² aufweist, wird unter einer Negativvorlage 30 s mit einer Metalihalogenidlampe von 5 kW Leistung belichtet.

Die belichtete Schicht wird mit einer Entwicklerlösung folgender Zusammensetzung
- 5 Gt: Natriumoctylsulfat,
- 1,5 Gt: Natriummetasilikat x 5 Wasser,
- 1 Gt: Trinatriumphosphat x 12 Wasser,
- 0,5 Gt: Dinatriumhydrogenphosphat x 12 Wasser,
- 92 Gt: Wasser

mit einem Plüschtampon behandelt, wobei die nichtbelichteten Schichtbereiche sauber entfernt werden, und anschließend mit Wasser abgespült und getrocknet.

In der Kopie ist die Stufe 4 eines Silberfilm-Halbtonstufenkeils mit einem Dichteumfang von 0,15 bis 1,50, wobei die Dichteinkremente 0,15 betragen, noch voll gedeckt.

Die so erhaltene Offsetdruckplatte liefert an einer Bogenoffsetmaschine viele Tausend tonfreie, saubere Drucke.

### Beispiel 2

24 Gt eines Copolymerisats aus Styrol und Allylalkohol, das 54 % Allylalkoholeinheiten und eine OH-Zahl von 192 aufweist, wird in 350 Gt Methylethylketon gelöst. Zu der klaren Lösung wird 1 Gt Maleinsäureanhydrid gegeben. Nachdem auch dieses in Lösung gegangen ist, werden 0,5 Gt Triethylamin hinzugefügt. Danach wird das Gemisch auf Rückflußtemperatur erwärmt und fünf Stunden bei dieser Temperatur gehalten. Anschließend wird die weitgehend klare Lösung abgekühlt, filtriert und in 5.000 Gt destilliertes Wasser eingetropft. Das erhaltene pulverige, weiße Produkt wird abgesaugt und, wie in Beispiel 1 beschrieben, getrocknet.

Die Ausbeute beträgt 25 Gt des Polymeren mit der Säurezahl 16.

Eine Beschichtungslösung aus
- 86,5 Gt: des oben beschriebenen Bindemittels,
- 29 Gt: des in Beispiel 1 beschriebenen Diazoniumsalz-Polykondensats,
- 3,5 Gt: Phosphorsäure (85 %),
- 4,3 Gt: Viktoriareinblau FGA und
- 2.000 Gt: Diethylenglykolmonomethylether,
- 2.000 Gt: Ethanol und
- 600 Gt: Butanon-2
wird auf eine in Salpetersäure elektrochemisch aufgerauhte und anschließend anodisierte Aluminiumfolie, die mit Polyvinylphosphonsäure nachbehandelt worden ist, aufgebracht. Das Trockengewicht beträgt 1,02 g/m².

Die Belichtung und Verarbeitung erfolgt wie in Beispiel 1 angegeben. Nach dem Einfärben erhält man eine gut farbannehmende Druckform, deren Nichtbildbereiche keine fette Farbe annehmen.

Nach dem Einspannen der Druckform in eine Bogenoffsetmaschine erhält man viele Tausend guter Drucke.

### Beispiel 3

Aus den folgenden Bestandteilen wird eine lichtempfindliche Schicht hergestellt:
- 0,45 Gt: eines Copolymeren aus 82 % Methylmethacrylat und 18 % Methacrylsäure (Säurezahl 117),
- 1,05 Gt: eines Polymeren, hergestellt durch Rückflußerhitzung unter Verwendung eines Polyvinylbutyrals mit einem Molekulargewicht von etwa 70- bis 80.000, das 71 % Vinylbutyral, 2 % Vinylacetat und 27 % Vinylalkoholeinheiten, Maleinsäureanhydrid, Methylethylketon und Trimethylamin enthält,
- 0,45 Gt: des Diazoniumsalz-Polykondensationsproduktes gemäß Beispiel 1,
- 0,04 Gt: 85%ige Phosphorsäure,
- 0,09 Gt: Viktoriareinblau FGA (C.I. Basic Blue 81),
- 1,5 Gt: Pentaerythrittetraacrylat/-triacrylat (techn. Gemisch),
- 0,007 Gt: Phenylazodiphenylamin,
- 0,12 Gt: 2-(4-Styryl-phenyl)-4,6-bis-trichlormethyl-s-triazin in
- 24 Gt: Diethylenglykolmonoethylether und
- 24 Gt: Tetrahydrofuran und
- 48 Gt: Butanon-2.

Das Schichtgewicht nach dem Trocknen beträgt 1,8 g/m².

Die Platte wird dann mit einer 15%igen wäßrigen Lösung von Polyvinylalkohol (12 % Restacetylgruppen, K-Wert 4) beschichtet. Nach dem Trocknen wird eine Deckschicht mit einem Gewicht von 1 g/m² erhalten.

Die Weiterverarbeitung erfolgt gemäß Beispiel 1. Von der entwickelten Platte lassen sich in einer Offsetdruckmaschine mehrere Tausend einwandfreie Drucke anfertigen.

### Vergleichsbeispiel 1

### (Lösemittelgemisch aus DE-A 38 07 406)

Analog zu Beispiel 1 wird eine Beschichtungslösung hergestellt aus
- 62 Gt: des Polymeren aus Beispiel 1,
- 21 Gt: des Diazoniumsalz-Polykondensationsprodukts aus Beispiel 1,
- 2,5 Gt: Phosphorsäure (85 %),
- 3 Gt: Viktoriareinblau FGA und
- 0,7 Gt: Phenylazodiphenylamin in
- 905 Gt: 1-Methoxyisopropanol,
- 1.100 Gt: Methyllactat,
- 1.300 Gt: Methylethylketon und
- 45 Gt: Diethylenglykolmonomethylether.

Anders als im Beispiel 1 konnte aus dem vorliegenden Gemisch auch bei längerem Rühren keine homogene Lösung erhalten werden. Ein Teil der Feststoffe bleibt ungelöst zurück.

Das hier angewandte und in der DE-A 38 07 406 beschriebene Lösemittelgemisch mit einem Gehalt an höhersiedendem Diethylenglykolmonomethylether von unter 2 Gew.-% (1,3 Gew.-%), bezogen auf die Komponenten des Lösemittelgemisches, zeigt daher gegenüber dem erfindungsgemäß verwendeten erhebliche Nachteile. Es ist völlig überraschend, daß eine Vergrößerung des Anteils an höhersiedendem Lösemittel diese Nachteile überwinden konnte.

### Vergleichsbeispiel 2

### (Lösemittelgemisch aus DE-A 20 34 655)

Analog zu Beispiel 1 wird eine Beschichtungslösung hergestellt aus
- 62 Gt: des Polymeren aus Beispiel 1,
- 21 Gt: des Diazoniumsalz-Polykondensationsprodukts aus Beispiel 1,
- 2,5 Gt: Phosphorsäure (85 %),
- 3 Gt: Viktoriareinblau FGA und
- 0,7 Gt: Phenylazodiphenylamin in
- 2.010 Gt: Ethylenglykolmonomethylether,
- 1.005 Gt: Tetrahydrofuran und
- 335 Gt: Butylacetat.

Das hier verwendete Lösemittelgemisch ist aus der DE-A 20 34 655 bekannt. Vergleicht man die Beschichtungslösungen aus Beispiel 1 mit dem hier eingesetzten, so stellt man folgendes fest:

Die Haltbarkeit der Lösung aus Vergleichsbeispiel 2 ist wesentlich kürzer als die des Beispiels 1. Die Lösung aus dem Vergleichsbeispiel kann nur wenige Stunden verwendet werden, weil Ausfällungen und Zersetzungen der Bestandteile die Lösung unbrauchbar machen. Die Lösung aus Beispiel 1 bleibt jedoch unter gleichen Bedingungen mehrere Tage verwendbar.

Außerdem können mit Hilfe des erfindungsgemäß verwendeten Lösemittelgemisches mehr Feststoffe, bezogen auf das Lösemittelvolumen, gelöst werden. Beim Vergleich der Beschichtungs- und Trocknungseigenschaften der Lösemittelgemische stellt man fest, daß mit dem erfindungsgemäß verwendeten Gemisch wesentlich gleichmäßigere Beschichtungen zu erhalten sind. Dadurch gelingt es, beim Druck von feinen Rasterpartien eine erheblich bessere Gleichmäßigkeit und bessere Druckqualität zu erreichen.

## Patentansprüche

1. Verfahren zur Herstellung einer negativ arbeitenden lichtempfindlichen, lithographischen Druckform, bei dem auf einen Träger ein in einer Lösemittelmischung gelöstes, negativ arbeitendes, lichtempfindliches Gemisch, das
a) ein negativ arbeitendes lichtempfindliches Diazoniumsalz-Polykondensationsprodukt enthält, das Diazoniumsalzeinheiten A-N₂X und andere, nicht lichtempfindliche Einheiten enthält, die von kondensationsfähigen Verbindungen, insbesondere aromatischen Aminen, Phenolen, Phenolethern, aromatischen Thioethern, aromatischen Kohlenwasserstoffen, aromatischen Heterocyclen und Carbonsäureamiden, abgeleitet sind, wobei sich die Einheiten A-N₂X von Verbindungen der Formel (R⁸-R⁹-)ₚR¹⁰-N₂X ableiten, worin
X das Anion der Diazoniumverbindung,
p eine ganze Zahl von 1 bis 3,
R⁸ einen aromatischen Rest mit mindestens einer zur Kondensation mit aktiver Carbonylverbundung befähigten Position,
R¹⁰ eine Phenylengruppe,
R⁹ eine Einfachbindung oder eine der Gruppen:
-(CH₂)_{q}-NR¹¹-,
-O-(CH₂)ᵣ-NR¹¹-,
-S-(CH₂)ᵣ-NR¹¹-,
-S-CH₂CO-NR¹¹-,
-O-R¹²-O-,
- O -,
- S -
oder
-CO-NR¹¹-
bedeuten, worin
q eine Zahl von 0 bis 5,
r eine Zahl von 2 bis 5,
R¹¹ Wasserstoff; eine Alkylgruppe mit 1 bis 5 C-Atomen, eine Aralkylgruppe mit 7 bis 12 C-Atomen oder eine Arylgruppe mit 6 bis 12 C-Atomen, und
R¹² eine Arylengruppe mit 6 bis 12 C-Atomen ist, und
b) ein in Wasser unlösliches, in wäßrig-alkalischer Lösung lösliches polymeres Bindemittel enthält,
aufgetragen und die erhaltene Schicht anschließend getrocknet wird, dadurch gekennzeichnet, daß als Lösemittelmischung ein Gemisch aus mehr als 10 und weniger als 50 Gew.-% mindestens eines Monoethers des Diethylenglykols und einem oder mehreren organischen Lösemittel(n) mit einem Siedepunkt unterhalb 200 °C verwendet wird.

2. Verfahren nach Anspruch 1, dadurch gekennzeichnet, daß es sich um Mono(C₁-C₄)alkylether des Diethylenglykols handelt.

3. Verfahren nach einem der Ansprüche 1 bis 3, dadurch gekennzeichnet, daß der Siedepunkt der niedrigsiedenden organischen Lösemittel bei 50 bis 150 °C liegt.

4. Verfahren nach einem der Ansprüche 1 bis 5, dadurch gekennzeichnet, daß das Gewichtsverhältnis von Monoalkylether des Diethylenglykols zu den anderen in dem Gemisch enthaltenen organischen Lösemitteln 1:1 bis 0,2:1, insbesondere 1:1 bis 0,4:1 beträgt.

5. Verfahren nach einem der Ansprüche 1 bis 6, dadurch gekennzeichnet, daß das niedrigsiedende Lösemittel ausgewählt ist aus der Gruppe der Lösemittel: Aceton, Butanon-2, Methanol, Ethanol, n-Propanol, iso-Propanol, n-Butanol, 1-Methoxyethanol-2, 1-Methoxypropanol-2, 2-Methoxypropanol-1, Amylalkohol, Tetrahydrofuran, 1,4-Dioxan, Wasser, Toluol, Diethylether, Diisopropylether, Dibutylether, 2-Methylfuran, Cyclohexanon, Methylisobutylketon, Methylpropylketon, Methylisopropylketon, Methylbutylketon, Ethylformiat, Propylformiat, Butylformiat, Methylacetat, Ethylacetat, Propylacetat, Butylacetat, Methylpropionat, Ethylenglykoldimethylether, Ethylenglykoldiethylether, Dimethylsulfoxid, Dimethylformamid, γ-Butyrolacton, Diacetonalkohol.

6. Verfahren nach einem der Ansprüche 1 bis 7, dadurch gekennzeichnet, daß die Trockenschichtmenge des negativ arbeitenden lichtempfindlichen Gemisches bei 0,3 bis 5 g/m², insbesondere bei 0,5 bis 3,5 g/m², liegt.

7. Verfahren nach einem der Ansprüche 1 bis 8, dadurch gekennzeichnet, daß das Trocknen der Schicht bei 50 bis 120 °C erfolgt.

8. Verfahren nach einem der Ansprüche 1 bis 9, dadurch gekennzeichnet, daß nach dem Trocknen der Schicht bildmäßig mit aktinischer Strahlung belichtet und anschließend mit einem wäßrig-alkalischen Entwickler entwickelt wird.

## Claims

1. Process for the production of a negative-working photosensitive lithographic printing member in which a negative-working, photosensitive mixture dissolved in a solvent mixture, the photosensitive mixture containing
a) a negative-working photosensitive diazonium salt polycondensation product, which contains diazonium salt units A-N₂X and other, non-photosensitive units derived from compounds capable of undergoing condensation, in particular from aromatic amines, phenols, phenol ethers, aromatic thioethers, aromatic hydrocarbons, aromatic heterocyclics and carboxylic acid amides, wherein the units A-N₂X are derived from compounds of the formula (R⁸-R⁹-)ₚR¹⁰-N₂X, in which
X means the diazonium compound anion,
p means an integer from 1 to 3,
R⁸ means an aromatic residue having at least one position capable of condensation with an active carbonyl compound,
R¹⁰ means a phenylene group,
R⁹ means a single bond or one or one of the groups:
-(CH₂)_{q}-NR¹¹-,
-O-(CH₂)ᵣ-NR¹¹-,
-S-(CH₂)ᵣ-NR¹¹-,
-S-CH₂CO-NR¹¹-,
-O-R¹²-O-,
-O-,
-S-
or
-CO-NR¹¹-
in which
q is a number from 0 to 5,
r is a number from 2 to 5,
R¹¹ is hydrogen, an alkyl group having 1 to 5 C atoms, an aralkyl groups having 7 to 12 C atoms or an aryl group having 6 to 12 C atoms, and
R¹² is an arylene group having 6 to 12 C atoms, and
b) a polymeric binder insoluble in water and soluble in an aqueous-alkaline solution,
is applied onto a support and the resultant layer is then dried, characterised in that the solvent mixture used is a mixture of more than 10 wt.% and less than 50 wt.% of at least one diethylene glycol monoether and one or more organic solvent(s) having a boiling point of below 200°C.

2. Process according to claim 1, characterised in that diethylene glycol mono(C₁-C₄)alkyl ethers are used.

3. Process according to claims 1 to 3, characterised in that the boiling point of the low-boiling organic solvent is from 50 to 150°C.

4. Process according to one of claims 1 to 5,
characterised in that the weight ratio of the diethylene glycol monoalkyl ether to the other organic solvents contained in the mixture is 1:1 to 0.2:1, particular 1:1 to 0.4:1.

5. Process according to one of claims 1 to 6,
characterised in that the low-boiling solvent is selected from the group of solvents: acetone, 2-butanone, methanol, ethanol, n-propanol, isopropanol, n-butanol, 1-methoxy-2-ethanol, 1-methoxy-2-propanol, 2-methoxy-1-propanol, amyl alcohol, tetrahydrofuran, 1,4-dioxane, water, toluene, diethyl ether, diisopropyl ether, dibutyl ether, 2-methylfuran, cyclohexanone, methyl isobutyl ketone, methyl propyl ketone, methyl isopropyl ketone, methyl butyl ketone, ethyl formate, propyl formate, butyl formate, methyl acetate, ethyl acetate, propyl acetate, butyl acetate, methyl propionate, ethylene glycol dimethyl ether, ethylene glycol diethyl ether, dimethyl sulphoxide, dimethylformamide, -butyrolactone, diacetone alcohol.

6. Process according to one of claims 1 to 7,
characterised in that the dry quantity of the layer of negative-working photosensitive mixture is 0.3 to 5 g/m², in particular 0.5 to 3.5 g/m².

7. Process according to one of claims 1 to 8,
characterised in that the layer is dried at 50 to 120°C.

8. Process according to one of claims 1 to 9,
characterised in that, once dried, the layer is exposed imagewise with actinic radiation and is then developed with an aqueous-alkaline developer.

## Revendications

1. Procédé de préparation d'une plaque lithographique photosensible négative, où on dépose sur un support un mélange photosensible, négatif, dissous dans un mélange de solvant qui contient
a) un produit de polycondensation de sel de diazonium photosensible négatif, qui contient des unités de sel de diazonium A-N₂X et d'autres unités non photosensibles, où les composés pouvant se condenser dérivent notamment d'amines aromatiques, de phénols, d'éthers de phénol, de thioéthers aromatiques, d'hydrocarbures aromatiques, d'hétérocycles aromatiques et d'amides d'acides carboxyliques, où les unités A-N₂X dérivent de composés de formule (R⁸-R⁹)ₚR¹⁰-N₂X, où
X est l'anion du composé diazonium,
p est un nombre entier de 1 à 3,
R⁸ est un reste aromatique ayant au moins une position permettant la condensation avec une liaison carbonyle active,
R¹⁰ est un groupe phénylène,
R⁹ est une liaison simple ou l'un des groupes :
-(CH₂)_{q}-NR¹¹-,
-O-(CH₂)ᵣ-NR¹¹-,
-S-(CH₂)-NR¹¹-,
-S-CH₂CO-NR¹¹-,
-O-R¹²-O-,
-O-,
-S-
ou
-CO-NR¹¹-
où
q est un nombre de 0 à 5,
r est un nombre de 2 à 5,
R¹¹ est un hydrogène, un groupe alkyle de 1 à 5 atomes de C, un groupe aralkyle ayant 7 à 12 atomes de C ou un groupe aryle ayant 6 à 12 atomes de C, et
R¹² est un groupe arylène ayant 6 à 12 atomes de C, et
b) un liant polymère soluble en solution aqueuse alcaline, insoluble dans l'eau, et on sèche ensuite la couche obtenue, caractérisée en ce qu'on utilise comme mélange solvant un mélange de plus de 10 % et de moins de 50 % en poids d'au moins un monoéther du diéthylèneglycol et d'un ou plusieurs solvants organiques ayant un point d'ébullition inférieur à 200°C.

2. Procédé selon la revendication 1, caractérisé en ce qu'il s'agit d'un monoéther alkylique C₁-C₄ du diéthylèneglycol.

3. Procédé selon l'une des revendications 1 à 3, caractérisé en ce que le point d'ébullition du solvant organique à point d'ébullition le plus faible se trouve entre 50 et 150°C.

4. Procédé selon l'une des revendications 1 à 5, caractérisé en ce que le rapport pondéral du monoéther alkylique du diéthylèneglycol aux autres solvants organiques compris dans le mélange est 1 : 1 à 0,2. 1, notamment 1 : 1 à 0,4 : 1.

5. Procédé selon l'une des revendications 1 à 6, caractérisé en ce que le solvant de bas point d'ébullition est choisi dans le groupe des solvants : acétone, butanone-2, méthanol, éthanol, n-propanol, isopropanol, n-butanol, 1-méthoxyéthanol-2, 1-méthoxypropanol-2, 2-méthoxypropanol-1, alcool amylique, tétrahydrofurane, 1,4-dioxane, eau, toluène, éther diéthylique, éther diisopropylique, éther dibutylique, 2-méthylfurane, cyclohexanone, méthylisobutylcétone, méthylpropylcétone, méthylisopropylcétone, méthylbutylcétone, formiate d'éthyle, formiate de propyle, formiate de butyle, acétate de méthyle, acétate d'éthyle, acétate de propyle, acétate de butyle, propionate de méthyle, éther diméthylique d'éthylèneglycol, éther diéthylique d'éthylèneglycol, diméthylsulfoxyde, diméthylformamide, γ-butyrolactone, diacétonealcool.

6. Procédé selon l'une des revendications 1 à 7, caractérisé en ce que la quantité de couche sèche du mélange photosensible négatif représente 0,3 à 5 g/m², notamment 0,5 à 3,5 g/m².

7. Procédé selon l'une des revendications 1 à 8, caractérisé en ce que le séchage de la couche a lieu entre 50 et 120°C.

8. Procédé selon l'une des revendications 1 à 9, caractérisé en ce qu'après le séchage de la couche on irradie pour former une image avec du rayonnement actinique et ensuite on développe avec un développateur soluble en milieu aqueux alcalin.
